# EUROPEAN PATENT SPECIFICATION

(11) **EP 3 335 413 B1**
(45) Date of publication and mention of the grant of the patent: **30.03.2022**
(21) Application number: 16757172.8
(22) Date of filing: 10.08.2016
(51) Int. Cl.: H04N 5/225, H05K 1/14

(54) **CAMERA FOR A MOTOR VEHICLE WITH AN ELECTRONIC UNIT ARRANGED ON THE LENS HOUSING AND MOTOR VEHICLE**
KAMERA FÜR EIN KRAFTFAHRZEUG MIT EINER AM OBJEKTIVGEHÄUSE ANGEORDNETEN ELEKTRONISCHEN EINHEIT UND KRAFTFAHRZEUG
CAMÉRA POUR UN VÉHICULE AUTOMOBILE, AYANT UNE UNITÉ ÉLECTRONIQUE PLACÉE SUR LE BOÎTIER D'OBJECTIF ET VÉHICULE AUTOMOBILE

(30) Priority: 11.08.2015 DE 102015113219
(43) Date of publication of application: 20.06.2018
(73) Proprietor: Connaught Electronics Ltd., Tuam, County Galway (IE)
(72) Inventor: O'CONNOR, Rachel, Tuam, County Galway (IE); MC VEIGH, Padraig, Tuam, County Galway (IE)
(74) Representative: Jauregui Urbahn, Kristian
(86) International application number: PCT/EP2016/069053
(87) International publication number: WO 2017/025568

(56) References cited:
- EP-A1- 1 662 778
- CN-U- 204 156 959
- US-A1- 2005 146 641
- US-A1- 2006 038 108
- US-A1- 2009 284 644
- US-A1- 2011 139 876

## Description

The present invention relates to a camera for a motor vehicle with a lens device including a lens housing and at least one lens, with a camera housing, in which the lens device is disposed at least in certain areas, and with camera electronics disposed within the camera housing. In addition, the present invention relates to a motor vehicle with at least one such camera. Finally, the present invention relates to a method for producing a camera for a motor vehicle.

Presently, the interest is in particular directed to cameras for motor vehicles. Such cameras can for example be a part of a driver assistance system of the motor vehicle, by which an environmental region of the motor vehicle can be captured. The environmental region of the motor vehicle captured by the cameras can for example be presented to the driver on a corresponding display device.

The cameras include a housing assembly, which is usually formed of two parts, namely a front housing and a rear housing. The front housing has a receiving area, in which at least one circuit board of the camera can be disposed. This at least one circuit board constitutes the camera electronics. Usually, a plurality of electronic components and corresponding traces are disposed on this at least one circuit board. Further, the front housing can serve for retaining a lens device of the camera. Therefore, the front housing can also be referred to as lens housing. The lens device in turn can include a lens housing, in which at least one lens is disposed.

The external dimensions of the housing assembly of the camera are usually preset by the vehicle manufacturers. Therein, there is the desire to form the camera and/or the housing assemblies thereof in a manner as installation space saving as possible on the one hand. On the other hand, increasingly more functions of the camera are to be provided. This results in increasingly more components being disposed on the circuit board and the circuit board thus requiring increasingly more space. US2005146641 A1 discloses a camera with a single circuit board carrying light sources around the lens housing.

It is the object of the present invention to demonstrate a solution, how additional functions can be provided by a camera for a motor vehicle and the camera can be formed in installation space saving manner at the same time.

According to the invention, this object is solved by a camera and by a motor vehicle having the features according to the respective independent claims.

Advantageous implementations of the invention are the subject matter of the dependent claims, of the description and of the figures.

A camera according to the invention for a motor vehicle includes a lens device including a lens housing and a lens. Moreover, the camera includes a camera housing, in which the lens device is disposed at least in certain areas. Moreover, the camera includes camera electronics disposed within the camera housing. Therein, the camera electronics includes an electronic unit disposed at an outside of the lens housing.

The camera can be disposed on or in a motor vehicle. The camera can for example be a part of a driver assistance system of the motor vehicle. For example, an environmental region of the motor vehicle can be captured by the camera. The camera includes a camera housing, which can for example have a front housing and a rear housing. The front housing and/or the rear housing can for example be manufactured of aluminum by means of a die casting method. Further, the camera includes a lens device including a lens housing and at least one lens, which is disposed within the lens housing. In particular, it is provided that the lens device includes a plurality of lenses disposed in the lens housing. The lens housing can also be formed of aluminum. Further, the lens device can include corresponding sealing elements, in particular sealing rings. Moreover, the camera includes camera electronics. For example, the camera electronics can include an image sensor. Furthermore, the camera electronics can include corresponding data storages, processors and the like for processing the data provided by the image sensor. Further, the camera electronics can include at least parts of the voltage supply of the camera. In addition, the camera electronics can include at least parts of a data interface, by means of which data can be transmitted from the camera to the motor vehicle. The camera electronics is disposed in the camera housing. In this manner, it can be protected from environmental influences. Further, electromagnetic interferences generated by the camera electronics can be prevented from being able to penetrate to the outside by the camera housing.

According to the invention, it is now provided that the camera electronics includes an electronic unit disposed at an outside of the lens housing. According to the prior art, it is provided that the camera electronics is disposed on at least one circuit board, which is disposed in the camera housing spaced from the lens device. Presently, it is now provided that at least a part of the camera electronics is disposed in an area associated with an outside or an outer surface of the lens device. For example, the electronic unit constituting a part of the camera electronics can be disposed at the outside or the outer surface of the lens housing. Thus, compared to known cameras employed in the motor vehicle field, an area is additionally provided, in which electronic components can be disposed. Thus, additional functions of the camera electronics can be integrated. At the same time, the camera can be formed in installation space saving manner.

In an embodiment, the electronic unit includes a plurality of electronic components and traces applied to the outside of the lens housing. The electronic unit can include a plurality of electronic components, which are electrically connected to each other by corresponding traces such that the electronic unit constitutes a part of the camera electronics. Therein, the electronic unit or the electronic components and the traces can be directly applied to the outside or the outer surface of the lens housing. It can also be provided that first an electrically insulating material is applied to the outside of the lens housing and subsequently the electronic components and the traces are applied. Herein, it can also be provided that the electronic components and/or the traces are applied by means of a printing method. Therefore, the electronic unit, thus a part of the camera electronics, can be integrated in the camera in particularly installation space saving manner.

In a further configuration, the lens housing has a first area, which is substantially cylindrically formed, and a second area, which has a larger outer diameter compared to the first area, wherein the first area is disposed within the camera housing and the second area is disposed in a through-opening of the camera housing at least in certain areas. The lens device can have two areas separated from each other. The first area can be substantially cylindrically formed and have a first outer diameter. The second area adjoining the first area can also be substantially cylindrically formed and have a larger, second outer diameter compared to the first outer diameter. A through-opening or a bore can be provided in the camera housing or in the front housing of the camera housing, in which the second area is disposed at least in certain areas. Thus, a part of the second area can be disposed outside of the camera housing and a part of the second area can be disposed within the camera housing. Therein, the second area further can be attached to the camera housing. Hereto, an adhesive connection can for example be used.

Preferably, the through-opening of the at least one circuit board is substantially roundly formed and the first area of the lens housing is inserted in the through-opening. The at least one circuit board can have a substantially round cross-sectional area. In addition, the at least one circuit board can have a round through-opening or bore. The first area of the lens device disposed within the camera housing can be passed through this through-opening. Thus, a particularly installation space saving arrangement of the camera electronics can be allowed.

According to a further embodiment, the second area has a recess, in which the at least one circuit board is disposed at least in certain areas. The second area of the lens device can also be referred to as cap. This second area can have a corresponding recess or cavity compared to known lens devices, in which the circuit board can be disposed. A corresponding retaining element for retaining the circuit board can be provided within the recess. Therein, it can basically also be provided that the electronic unit has multiple circuit boards, wherein for example one of the circuit boards is disposed in the first area and at least one further is disposed in the recess of the second area.

Furthermore, it is advantageous if the electronic unit has a plurality of circuit boards, which are electrically connected to each other by means of a flexible connecting element. The individual circuit boards can for example be connected to each other by corresponding wires. Preferably, the plurality of circuit boards is electrically connected to each other by flexible connecting lines or traces disposed on a flexible support. As already explained, the plurality of circuit boards can be disposed in the first area and/or the second area of the lens device. It can also be provided that the camera electronics has a further circuit board, which is disposed in the camera housing behind the lens device. In particular, the image sensor of the camera electronics can be disposed on this further circuit board. This circuit board too can be electrically connected to the plurality of circuit boards of the electronic unit.

Preferably, the camera has a motor vehicle fixing device for fixing the camera to the motor vehicle. In particular, the camera can be attached externally on the motor vehicle. Hereto, a corresponding receiving device can be provided on the motor vehicle, on which the motor vehicle fixing device of the camera can be disposed.

A motor vehicle according to the invention includes at least one camera according to the invention. Therein, it can also be provided that multiple cameras are disposed distributed on the motor vehicle. The cameras can for example be a part of a driver assistance system of the motor vehicle, by which an environmental region of the motor vehicle can be captured. The motor vehicle is in particular formed as a passenger car.

Further features of the invention are apparent from the claims, the figures and the description of figures.

Now, the invention is explained in more detail based on preferred embodiments as well as with reference to the attached drawings.

There show:
- Fig. 1: a motor vehicle according to an embodiment of the present invention, which has a driver assistance system with four cameras;
- Fig. 2: a camera having a camera housing as well as a lens device;
- Fig. 3: a schematic illustration of the camera in a sectioned side view;
- Fig. 4: the lens device having a first area and a second area, wherein a recess for a circuit board is present in the second area;
- Fig. 5: the lens device according to Fig. 4, wherein the circuit board is disposed in the recess;
- Fig. 6: the lens device in a sectioned side view, wherein a plurality of circuit boards is disposed in the first area; and
- Fig. 7: a camera according to a further embodiment in a perspective view.

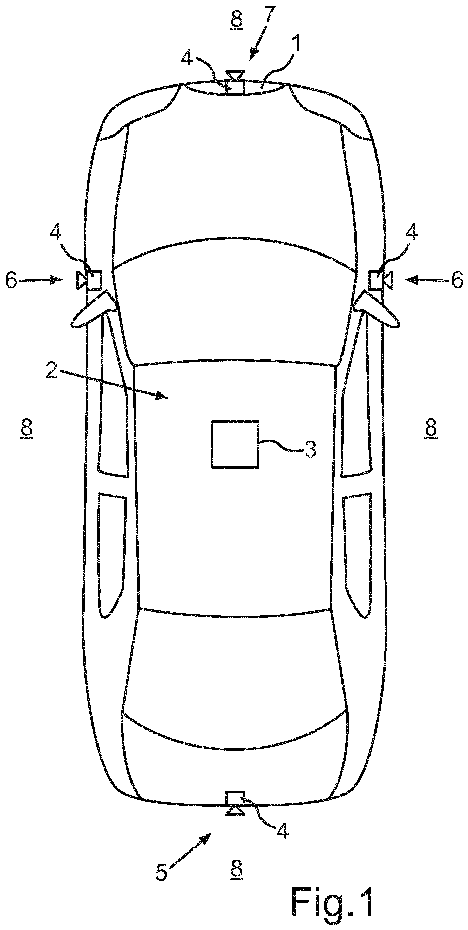

Fig. 1 shows a motor vehicle 1 according to an embodiment of the present invention in a plan view. In the present case, the motor vehicle 1 is formed as a passenger car. The motor vehicle 1 includes a driver assistance system 2. The driver assistance system 2 in turn includes a control device 3, which can for example be constituted by an electronic control unit of the motor vehicle 1. Moreover, the driver assistance system 2 includes at least one camera 4. In the present embodiment, the driver assistance system 2 includes four cameras 4, which are disposed distributed on the motor vehicle 1. Presently, one of the cameras 4 is disposed in a rear area 5, one of the cameras 4 is disposed in a front area 7 of the motor vehicle 1 and the remaining two cameras 4 are disposed in a respective lateral area 6, in particular in an area of the wing mirrors. Presently, the number and arrangement of the cameras 4 of the driver assistance system 2 is to be understood purely exemplarily.

An environmental region 8 of the motor vehicle 1 can be captured by the cameras 4. Preferably, the four cameras 4 are formed identical in construction. In particular, an image sequence or video data can be provided by the cameras 4, which describes the environmental region 8. This video data can be transmitted from the cameras 4 to the control device 3. A display device of the motor vehicle 1 not illustrated here can be controlled by means of the control device 3 such that the video data of the cameras 4 can be displayed to the driver. Thus, the driver assistance system 2 serves for assisting the driver of the motor vehicle 1 in driving the motor vehicle 1. The driver assistance system 2 can for example be a so-called electronic rearview mirror.

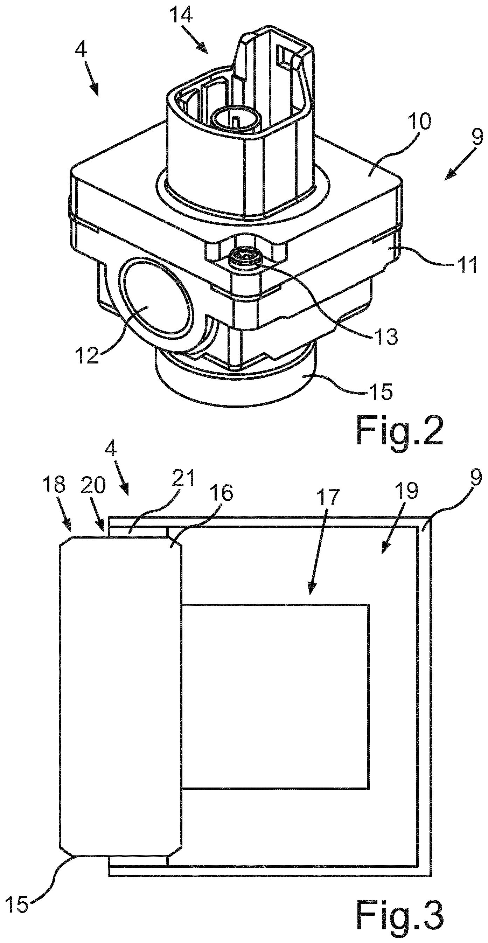

Fig. 2 shows one of the cameras 4 according to a first embodiment. The camera 4 includes a camera housing 9, which in turn includes a front housing 11 and a rear housing 10. A lens device 15 of the camera 4 is disposed on the front housing 11, which can include at least one lens. Moreover, a vent 12 is disposed in the front housing 11. The front housing 11 and the rear housing 10 can be formed of aluminum and be manufactured by means of a die casting method. In addition, the front housing 11 and the rear housing 10 can have an electrically insulating coating. The front housing 11 and the rear housing 10 are connected to each other by means of screws 13. Moreover, the camera 4 has an interface device 14. Data transmission from the camera 4 to the motor vehicle 1 can be effected via the interface device 14. In this manner, the image sequences or video data provided by the camera 4 can be presented on a display device of the motor vehicle 1.

Fig. 3 shows a severely simplified illustration of the camera 4 in a sectioned side view. Here, the lens device 15 is apparent, which has a lens housing 16. One or more lenses not illustrated here can be disposed in the lens housing 16, which can for example be manufactured of aluminum. Further, it is apparent that the lens device 15 has a first area 17 and a second area 18. The lens device 15 is substantially cylindrically formed and has a first outer diameter in the first area 17. The first area 17 is disposed in the interior 19 of the camera housing 9. The lens device 15 is also substantially cylindrically formed and has a second outer diameter in the second area 18, which is larger than the first outer diameter. Therein, the second area 18 of the lens device 15 is disposed in a through-opening 20 of the camera housing 9. The second area 18 is connected to the camera housing 9 by means of adhesive 21. Thus, a part of the second area 18 is disposed in the interior 19 of the camera housing 9 and a second part is disposed outside of the camera housing 9.

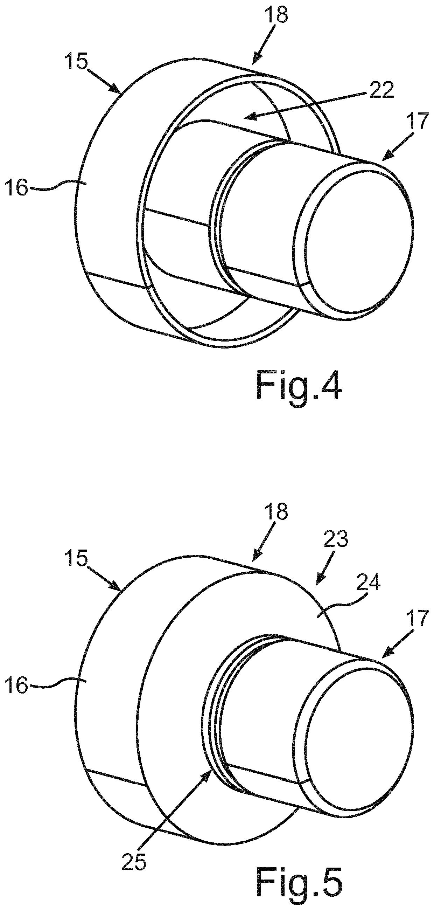

Fig. 4 shows the lens device 15 according to a further embodiment in a perspective view. Here, the first area 17 is apparent, which is substantially cylindrically formed. The second area 18, which can also be referred to as cap, has a recess 22 or a cavity. As is apparent from Fig. 5, an electronic constituent 23 of camera electronics 27 of the camera 4 can be disposed in this recess 22. The electronic constituent 23 includes a circuit board 24 in the present case. The circuit board 24 substantially has a round cross-sectional area. Further, the circuit board 24 has a through-opening 25, through which the lens device 15 is passed at least in certain areas.

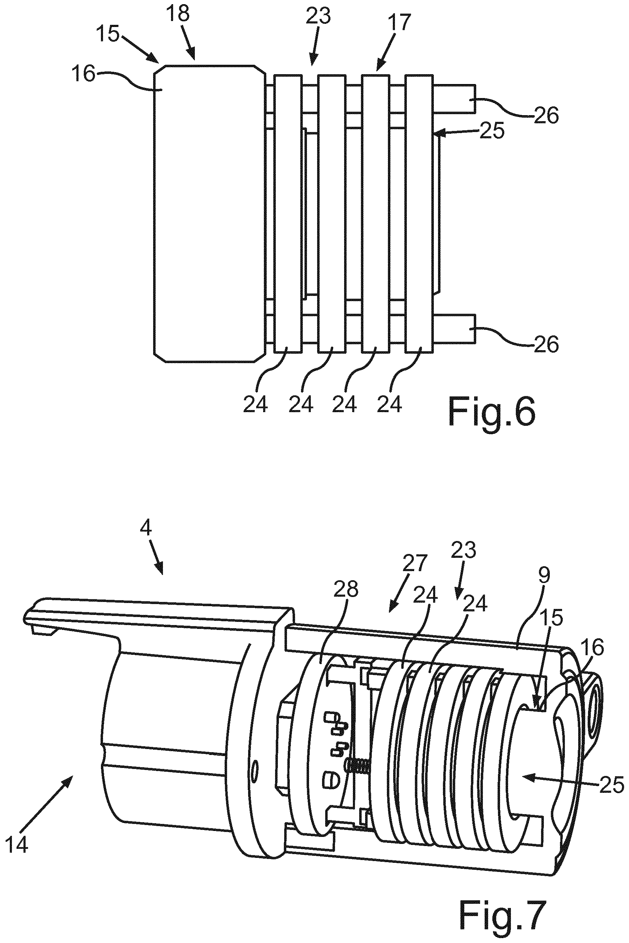

Fig. 6 shows the lens device 15 in a further embodiment. Herein, the electronic constituent 23 disposed on the lens device 15 includes four circuit boards 24., Here too, the circuit boards 24 are formed such that they substantially have a round cross-sectional area. In addition, the circuit boards 24 have a through-opening 25, which is presently configured such that they can be disposed on the first area 17 of the lens device 15. Presently, the circuit boards 24 are disposed parallel to each other and have a predetermined distance to each other. Moreover, flexible connecting lines 26 are provided, by which the circuit boards 24 are electrically connected to each other.

Fig. 7 shows the camera 4 according to a further embodiment. Herein, the lens device 15 is substantially cylindrically formed. A plurality of circuit boards 24 with corresponding through-openings 25 is disposed around the outside of the lens device 15. The camera housing 9 too is substantially cylindrically formed in the present case. Electronic components and corresponding traces can be disposed on the respective circuit boards 24 constituting the electronic constituent 23. These electronic components can be corresponding processors, by which the image data captured by the camera 4 can be further processed. In addition, the electronic components can be parts of the voltage supply of the camera 4. The electronic components can also serve for providing a data connection between the camera 4 and the motor vehicle 1.

In the embodiment of Fig. 7, the camera electronics 27 includes a further circuit board 28, which is disposed behind the lens device 15. For example, the image sensor of the camera 4 can be disposed on this further circuit board 28. By the electronic constituent 23 and the circuit boards 24 thereof, which are disposed in the first area 17 and/or the second area 18 around the lens device 15, a particularly installation space saving arrangement can be achieved. In addition, additional components can be disposed on the circuit boards 24 and thus additional camera functions can be provided. Basically, it can also be provided that the electronic components and the traces of the electronic unit 23 are directly applied to an outer surface of the lens device 15.

## Claims

1. Camera (4) for a passenger car with a lens device (15) including a lens housing (16) and at least one lens, with a camera housing (9), in which the lens device (15) is disposed at least in certain areas, and with camera electronics (27) disposed within the camera housing (9),
**characterized in that**
the camera electronics (27) includes an electronic unit (23), which is disposed at an outside of the lens housing (16),
the electronic unit (23) includes a plurality of electronic components and traces, which are disposed on a plurality of circuit boards (24), wherein the plurality of circuit boards (24) surrounds the lens housing (16) at least in certain areas and
the plurality of circuit boards (24) has a through-opening (25), in which the lens housing (16) is disposed at least in certain areas and the circuit boards (24) are disposed substantially parallel to each other.

2. Camera (4) according to claim 1,
**characterized in that**
the electronic unit (23) includes a plurality of electronic components and traces, which are applied to the outside of the lens housing (15).

3. Camera (4) according to any one of the preceding claims,
**characterized in that**
the lens housing (15) has a first area (17), which is substantially cylindrically formed, and a second area (18), which has a larger outer diameter compared to the first area, wherein the first area (17) is disposed within the camera housing (9) and the second area (18) is disposed in a through-opening (20) of the camera housing (9) at least in certain areas.

4. Camera (4) according to claim 3,
**characterized in that**
the through-opening (25) of the plurality of circuit boards (24) is substantially roundly formed and the first area (17) of the lens housing (15) is inserted in the through-opening (25).

5. Camera (4) according to claim 4,
**characterized in that**
the second area (18) has a recess (22), in which the plurality of circuit boards (24) is disposed at least in certain areas.

6. Camera (4) according to any one of the preceding claims,
**characterized in that**
the plurality of circuit boards (24) are electrically connected to each other by means of a flexible connecting element (26).

7. Camera (4) according to any one of the preceding claims,
**characterized in that**
the camera (4) has a motor vehicle fixing device for fixing the camera (4) to the motor vehicle.

8. Motor vehicle (1) with at least one camera (4) according to any one of the preceding claims.

## Patentansprüche

1. Kamera (4) für einen Personenwagen mit einer Objektiveinrichtung (15) einschließlich eines Objektivgehäuses (16) und mindestens eines Objektivs, mit einem Kameragehäuse (9), in dem die Objektiveinrichtung (15) in mindestens gewissen Bereichen angeordnet ist, und mit einer Kameraelektronik (27), die innerhalb des Kameragehäuses (9) angeordnet ist,
**dadurch gekennzeichnet, dass**
die Kameraelektronik (27) eine Elektronikeinheit (23) enthält, die an einer Außenseite des Objektivgehäuses (16) angeordnet ist,
die Elektronikeinheit (23) mehrere Elektronikkomponenten und -bahnen enthält, die auf mehreren Leiterplatten (24) angeordnet sind, wobei die mehreren Leiterplatten (24) das Objektivgehäuse (16) mindestens in gewissen Bereichen umgeben und die mehreren Leiterplatten (24) eine Durchgangsöffnung (25) aufweisen, in der das Objektivgehäuse (16) mindestens in gewissen Bereichen angeordnet ist, und die Leiterplatten (24) im Wesentlichen parallel zueinander angeordnet sind.

2. Kamera (4) nach Anspruch 1,
**dadurch gekennzeichnet, dass**
die Elektronikeinheit (23) mehrere Elektronikkomponenten und -bahnen enthält, die an der Außenseite des Objektivgehäuses (15) angebracht sind.

3. Kamera (4) nach einem der vorhergehenden Ansprüche,
**dadurch gekennzeichnet, dass**
das Objektivgehäuse (15) einen ersten Bereich (17) aufweist, der im Wesentlichen zylindrisch ausgebildet ist,
und einen zweiten Bereich (18), der im Vergleich zu dem ersten Bereich einen größeren Außendurchmesser aufweist, wobei der erste Bereich (17) innerhalb des Kameragehäuses (9) angeordnet ist, und der zweite Bereich (18) in einer Durchgangsöffnung (20) des Kameragehäuses (9) mindestens in gewissen Bereichen angeordnet ist.

4. Kamera (4) nach Anspruch 3,
**dadurch gekennzeichnet, dass**
die Durchgangsöffnung (25) der mehreren Leiterplatten (24) im Wesentlichen rund gebildet ist und der erste Bereich (17) des Objektivgehäuses (15) in die Durchgangsöffnung (25) eingesetzt ist.

5. Kamera (4) nach Anspruch 4,
**dadurch gekennzeichnet, dass**
der zweite Bereich (18) eine Ausnehmung (22) aufweist, in der die mehreren Leiterplatten (24) mindestens in gewissen Bereichen angeordnet sind.

6. Kamera (4) nach einem der vorhergehenden Ansprüche,
**dadurch gekennzeichnet, dass**
die mehreren Leiterplatten (24) mit Hilfe eines flexiblen Verbindungselements (26) elektrisch miteinander verbunden sind.

7. Kamera (4) nach einem der vorhergehenden Ansprüche,
**dadurch gekennzeichnet, dass**
die Kamera (4) eine Kraftfahrzeugfixiereinrichtung zum Fixieren der Kamera (4) an dem Kraftfahrzeug aufweist.

8. Kraftfahrzeug (1) mit mindestens einer Kamera (4) nach einem der vorhergehenden Ansprüche.

## Revendications

1. Caméra (4) pour une voiture de tourisme pourvue d'un dispositif objectif (15) comportant un boîtier d'objectif (16) et au moins une lentille, pourvue d'un boîtier de caméra (9), dans lequel est placé le dispositif objectif (15) au moins dans certaines régions, et pourvue d'électronique de caméra (27) placée à l'intérieur du boîtier de caméra (9),
**caractérisée en ce que**
l'électronique de caméra (27) comporte une unité électronique (23), qui est placée au niveau d'un côté extérieur du boîtier d'objectif (16),
l'unité électronique (23) comporte une pluralité de composants électroniques et de traces, placés sur une pluralité de cartes de circuit (24), la pluralité de cartes de circuit (24) entourant le boîtier d'objectif (16) au moins dans certaines régions et la pluralité de cartes de circuit (24) est pourvue d'une ouverture traversante (25), dans laquelle est placé le boîtier d'objectif (16) au moins dans certaines régions, et les cartes de circuit (24) sont placées sensiblement parallèlement les unes aux autres.

2. Caméra (4) selon la revendication 1,
**caractérisée en ce que**
l'unité électronique (23) comporte une pluralité de composants électroniques et de traces, appliqués sur le côté extérieur du boîtier d'objectif (15).

3. Caméra (4) selon l'une quelconque des revendications précédentes,
**caractérisée en ce que**
le boîtier d'objectif (15) est pourvu d'une première région (17) dotée d'une forme sensiblement cylindrique et d'une deuxième région (18) pourvue d'un diamètre extérieur plus grand que celui de la première région, la première région (17) étant placée à l'intérieur du boîtier d'objectif (9) et la deuxième région (18) étant placée dans une ouverture traversante (20) du boîtier de caméra (9) au moins dans certaines régions.

4. Caméra (4) selon la revendication 3,
**caractérisée en ce que**
l'ouverture traversante (25) de la pluralité de cartes de circuit (24) est dotée d'une forme sensiblement ronde et la première région (17) du boîtier d'objectif (15) est introduite dans l'ouverture traversante (25).

5. Caméra (4) selon la revendication 4,
**caractérisée en ce que**
la deuxième région (18) est pourvue d'un renfoncement (22) dans lequel est placée la pluralité de cartes de circuit (24) au moins dans certaines zones.

6. Caméra (4) selon l'une quelconque des revendications précédentes,
**caractérisée en ce que**
la pluralité de cartes de circuit (24) sont reliées électriquement entre elles au moyen d'un élément de liaison souple (26).

7. Caméra (4) selon l'une quelconque des revendications précédentes,
**caractérisée en ce que**
la caméra (4) est pourvue d'un dispositif de fixation à un véhicule motorisé permettant de fixer la caméra (4) au véhicule motorisé.

8. Véhicule motorisé (1) pourvu d'au moins une caméra (4) selon l'une quelconque des revendications précédentes.
